# EUROPÄISCHE PATENTANMELDUNG

(11) **EP 3 392 916 A1**
(43) Veröffentlichungstag der Anmeldung: **24.10.2018**
(21) Anmeldenummer: 17166965.8
(22) Anmeldetag: 19.04.2017
(51) Int. Cl.: H01L 31/05

(54) **ALTERUNGSRESISTENTE ALUMINIUMVERBINDER FÜR SOLARZELLEN**

(71) Anmelder: Heraeus Deutschland GmbH & Co. KG, 63450 Hanau (DE)
(72) Erfinder: Henning, Andreas, 36391 Sinntal-Morrgers (DE); Koenig, Markus, 64807 Dieburg (DE)
(74) Vertreter: Heraeus IP

(57) **Zusammenfassung**

Die vorliegende Erfindung betrifft einen Verbinder zum Verbinden einer Solarzellenelektrode mit einem weiteren Element, wobei der Verbinder eine Leiterstruktur umfasst, auf der mindestens eine metallische Beschichtung angeordnet ist, wobei die Leiterstruktur Aluminium enthält, dadurch gekennzeichnet, dass die Beschichtung ein Element enthält, das aus der Gruppe ausgewählt ist, die aus Ni, Ag, Sn, Pb, Zn, Bi, In, Sb, Co, Cr sowie Legierungen dieser Elemente besteht.

## Beschreibung

Die vorliegende Erfindung betrifft Verbinder zum Verbinden einer Solarzellenelektrode mit einem weiteren Element, wobei der Verbinder Aluminium enthält. Außerdem betrifft die Erfindung ein Photovoltaikbauteil umfassend eine Solarzelle, bei dem die Elektrode einer Solarzelle über den erfindungsgemäßen Verbinder mit einem weiteren Element verbunden ist.

Typischer Weise enthält eine Solarzelle mindestens die folgenden Bestandteile: eine Halbleiterschicht, die optional eine zusätzliche Dotierung (p- oder n-Typ) aufweist; mindestens eine Frontseitenelektrode auf der Seite, auf der das Sonnenlicht auf die Solarzelle einfällt, und mindestens eine Rückseitenelektrode auf der Seite, die vom Sonnenlicht abgewandt ist.

Für viele Anwendungen werden einzelne Solarzellen mit Hilfe eines Verbinders in Reihe geschaltet und zu Photovoltaikmodulen verbunden. Dabei wird eine Frontseitenelektrode einer Solarzelle über einen Verbinder mit der Rückseitenelektrode einer weiteren Solarzelle verbunden.

Um mehrere Solarzellen über ihre Elektroden zu Photovoltaikmodulen zu verbinden, werden meistens Kupferbändern eingesetzt. Solche Kupferbänder weisen häufig eine Lotbeschichtung auf, die vor dem Verbinden auf die Kupferbänder aufgetragen werden kann. Als Lotmaterialien für die Beschichtungen kommen hier beispielsweise Zinn oder zinnhaltige Legierungen zum Einsatz. Solche mit dem Lot vorbeschichteten Kupferbänder werden mit den Elektroden einer Solarzelle in Kontakt gebracht und durch Erhitzen miteinander verlötet. Diese Technologie erlaubt die Herstellung hochleitfähiger, mechanisch fester Verbindungen zwischen einzelnen Solarzellen. Die Beschichtung des Kupferbandes mit einem Lotmaterial kann zusätzlich einen Schutz gegen Korrosion des Verbinders bewirken. Alternativ werden bekannte Verbinder auch mittels leitfähiger Kleber mit Solarzellen verbunden. Aus der EP2234180A2 sind Photovoltaikmodule bekannt, bei denen einzelne Solarzellen über einen elektrisch leitfähigen Klebefilm mit Kupferverbindern verbunden sind. Da die Materialkosten für Kupferverbinder hoch sind, ist es wünschenswert Verbinder aus einem günstigeren Material zu verwenden, die eine ähnlich gute elektrische Leitfähigkeit wie Kupfer aufweisen.

Auf Grund der guten elektrischen Leitfähigkeit und der niedrigen Materialkosten besitzt Aluminium vorteilhafte Eigenschaften zur Verschaltung von elektrischen Bauteilen, wie zum Beispiel Silizium-Solarzellen. Hinzu kommt, dass Aluminium einen unedlen Charakter besitzt und eine native Oxidschicht an der Oberfläche bildet. Diese Oxidschicht kann das Metall passivieren und vor weiterer Korrosion durch Oxidation schützen. Allerdings weisen Aluminiumverbinder auch gewisse Nachteile auf.

Photovoltaikmodule aus mehreren Solarzellen sind häufig mit einer Polymerschutzschicht versehen. Diese Polymerschutzschicht enthält häufig Polyestern. Diese Polyester können unter Einwirkung von Wärme und Feuchtigkeit sauer wirkende Bestandteile freisetzen, wie z. B. Essigsäure.

In saurer und feuchter Umgebung sind Aluminiumverbinder trotz einer vorhandenen Passivierungsschicht häufig nicht ausreichend korrosionsstabil. Metallisches Aluminium wird nach und nach zu Aluminiumoxid umgewandelt. Da Aluminiumoxid elektrisch isolierend ist, wird die Leitfähigkeit des Aluminiumverbinders durch die Korrosion verringert und wirkt sich dadurch negative auf die Leistung der Solarzelle aus. Insbesondere an der Kontaktfläche zwischen Verbinder und Solarzellenelektrode kann die Korrosion sehr nachteilig sein. Aus US20150122378A1 sind Aluminiumverbinder bekannt, bei denen Aluminium mit Elementen wie Sc, Mg und Zr dotiert ist. Durch diese Dotierung soll die Korrosionsbeständigkeit der Verbinder unter sauren Bedingungen verbessert werden.

Ein direktes Belöten der Oberfläche des Aluminiumverbinders ist nicht möglich, da beim Auftragen von flüssigem Lot eine dünne Aluminiumoxidschicht auf dem Verbinder entsteht, die eine ausreichende Haftung des Lotmaterials verhindert. Somit wird auch eine elektrische Kontaktierung beeinträchtigt.

Die Aufgabe der vorliegenden Erfindung bestand darin, Aluminiumverbinder für Solarzellen bereitzustellen, die gegen Korrosion geschützt sind und gleichzeitig Solarzellen mechanisch stabil zu Modulen verbinden können.

Eine weitere bevorzugte Aufgabe der Erfindung besteht darin, Verbinder für Solarzellenelektroden bereitzustellen, die so ausgelegt sind, dass die Nutzungseffizienz für das auf die Solarzelle einfallende Licht verbessert wird.

### Beschreibung der Erfindung

Figuren zur Veranschaulichung der Erfindung:
Figur 1: Leiterstruktur mit metallischer Beschichtung
Figur 2: Leiterstruktur mit metallischer Beschichtung, wobei die Beschichtung eine Strukturierung aufweist
Figur 3: Verbinden des Verbinders mit einer Solarzellenelektrode über die gesamte senkrechte Projektionsfläche des Verbinders. Die Pfeile geben die Richtung senkrecht zur Oberfläche der Halbleiterschicht an.
Figur 4: Beispielhafter Querschnitt der Verbindung zwischen Verbinder und Solarzellenelektrode in einem erfindungsgemäßen Photovoltaikmodul

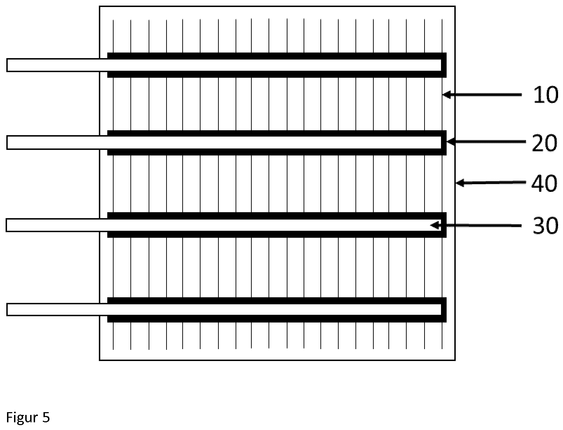

Figur 5: Aufsicht auf eine Solarzelle mit Verbinder

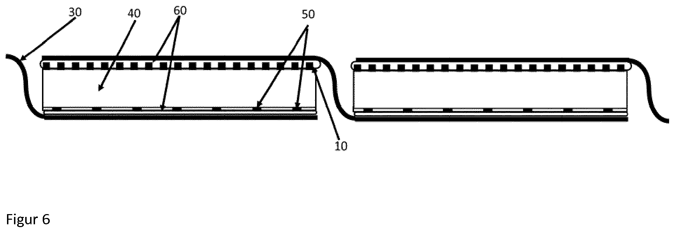

Figur 6: Zwei über einen Verbinder zu einem Photovoltaikmodul verbundenen Solarzellen Die Aufgabe wird gelöst durch einen Verbinder zum Verbinden einer Solarzellenelektrode mit einem weiteren Element, wobei der Verbinder eine Leiterstruktur umfasst, auf der mindestens eine metallische Beschichtung angeordnet ist, wobei die Leiterstruktur Aluminium enthält, dadurch gekennzeichnet, dass die Beschichtung ein Element enthält, das aus der Gruppe ausgewählt ist, die aus Ni, Ag, Sn, Pb, Zn, Bi, In, Sb, Co, Cr sowie Legierungen dieser Elemente besteht.

Der erfindungsgemäße Verbinder dient dem elektrischen und mechanischen Verbinden von Solarzellenelektroden mit einem weiteren Element. Das weitere Element kann eine Anschlussleitung für eine Photovoltaikmodul oder eine weitere Solarzellenelektrode sein. Wenn das weitere Element eine weitere Solarzellenelektrode ist, lassen sich mit dem Verbinder mehrere Solarzellen zu einem Photovoltaikmodul in einer Reihenschaltung verbinden. Um fehlerfreie Funktion des Photovoltaikmoduls über die gesamte Betriebsdauer zu gewährleisten, ist eine mechanisch robuste und elektrisch leitfähige Verbindung zwischen den Elektroden erforderlich. Die Verbindung ist verschiedenen Belastungen ausgesetzt. Beispielsweise ist die Verbindung zwischen Verbinder und Solarzellenelektrode bei der Fertigung oder bei zyklischen Temperaturwechsel während des Betriebs unterschiedlichen Temperaturen ausgesetzt. Die unterschiedlichen thermischen Ausdehnungskoeffizienten der beteiligten Materialien führen zu mechanischen Spannungen zwischen Solarzellenelektrode und Verbinder. Zusätzlich ist der Zellverbinder, unter anderem wegen der fließenden Ströme, der Korrosion, z.B. durch Oxidation, ausgesetzt. Die genannten Beanspruchungen können dafür sorgen, dass der elektrische und mechanische Kontakt mit dem Verbinder über die Nutzungsdauer der Solarzelle abnimmt oder komplett versagt.

Der Verbinder umfasst eine Leiterstruktur wobei die Leiterstruktur Aluminium enthält. Bevorzugt besteht die Leiterstruktur aus Aluminium. In einer weiteren bevorzugten Ausführungsform kann die Leiterstruktur auch eine Aluminiumlegierung enthalten oder aus einer Aluminiumlegierung bestehen.

In einer bevorzugten Ausführungsform ist die Leiterstruktur ein Draht oder ein Band. Der Aluminiumdraht kann bevorzugt einen Querschnitt aufweisen der kreisförmig oder oval ist. Für den Fall, dass die Leiterstruktur ein Band ist, liegt die bevorzugte Breite im Bereich von 200 µm - 2 mm. Die bevorzugte Dicke des Bandes liegt im Bereich von 50 µm - 350 µm. Der bevorzugte maximale Durchmesser des Drahts liegt im Bereich von 50 µm - 350 µm.

Auf der Leiterstruktur ist mindestens eine metallische Beschichtung angeordnet. In einer bevorzugten Ausführung ist die Oberfläche der Leiterstruktur im Wesentlichen vollständig mit der metallischen Beschichtung bedeckt. Im Wesentlichen vollständig meint im vorliegenden Fall, dass die Leiterstruktur auf der gesamten Oberfläche entlang der Hauptachse mit der Beschichtung stoffschlüssig bedeckt ist. Diese vollständige Beschichtung wird auch Mantel oder *Coating* genannt. Unter der Hauptachse der Leiterstruktur ist im Kontext der Erfindung die Achse entlang der längsten Ausdehnung der Leiterstruktur zu verstehen. Bevorzugt ist die Leiterstruktur lediglich an den Enden offenen, so dass die metallische Beschichtung an den Enden der Leiterstruktur unvollständig ist. In einer weiteren Bevorzugten Ausführungsform kann die Beschichtung auch die Enden der Leiterstruktur vollständig bedecken, so dass die Leiterstruktur vollumfänglich umschlossen ist. Wenn die Leiterstruktur vollumfänglich von einer metallischen Beschichtung umschlossen ist, ist die Leiterstruktur von außen nicht mehr zugänglich.

In einer anderen bevorzugten Ausführungsform ist die Leiterstruktur nicht vollständig entlang des Umfangs der Leiterstruktur mit einer metallischen Beschichtung beschichtet. Insbesondere kann es bevorzugt sein, dass die Leiterstruktur nur dort mit einer metallischen Beschichtung versehen ist, wo später der Kontakt mit den Elektroden einer Solarzelle hergestellt wird. Diese Ausführung kann Beschichtungsmaterial sparen und gleichzeitig eine korrosionsfreie Kontaktfläche sicherstellen.

Um einen guten Kontakt zwischen der Aluminium enthaltenden Leiterstruktur und der metallischen Beschichtung herstellen zu können, ist es bevorzugt, dass die Leiterstruktur auf der Oberfläche keine passivierende Oxidschicht aufweist, dass also möglichst metallisches Aluminium vorliegt. Wie eine möglichst oxidfreie Aluminiumoberfläche der Leiterstruktur erreicht werden kann ist dem Fachmann grundsätzlich bekannt. Zum Beispiel kann dies erreicht werden, durch mechanischem Materialabtrag, Plasmaätzen, galvanische Reduktion oder chemische Reduktion. Optional können die vorgenannten Verfahren zum Entfernen der Oxidschicht in einer Schutzgasatmosphäre durchgeführt werden, um Re-oxidation der freien Aluminiumoberfläche zu vermeiden.

Die metallische Beschichtung kann die Leiterstruktur vor Korrosion unter sauren Bedingungen schützen. Dadurch kann die Oxidation von Aluminium verhindert werden, sodass die elektrische Leitfähigkeit des Verbinders, insbesondere im Bereich der Kontaktfläche zur Solarzellenelektrode, dauerhaft erhalten bleibt. Bevorzugt beträgt die Dicke der metallischen Beschichtung 10 nm - 25 µm, insbesondere 0,1 µm - 5 µm.

In einer bevorzugten Ausführungsform kann die metallische Beschichtung ein Element enthalten, das ausgewählt ist aus der Gruppe bestehend aus Ni, Ag, Sn, Pb, Zn, Bi, In, Sb, Co, Cr sowie Legierungen dieser genannten Elemente. Bevorzugt enthält die metallische Beschichtung eine Legierung aus mindestens zwei dieser genannten Elemente. Besonders bevorzugt enthält die Beschichtung zumindest ein Element, das ausgewählt ist aus Ni, Ag und Sn. Ganz besonders bevorzugt besteht die metallische Beschichtung aus Ni, Ag oder einer SnPb-Legierung. In einer bevorzugten Ausführungsform wird die metallische Beschichtung so gewählt, dass diese Beschichtung selber unter sauren Bedingungen (z.B. pH-Wert 4 - 6,5), so wie sie in einem Photovoltaikmodul vorherrschen können, keine Oxidschicht auf ihrer Oberfläche bilden. Eine oxidfreie Oberfläche auf dem erfindungsgemäßen Verbinder ermöglicht eine dauerhafte, stabile Verbindung mit Solarzellenelektroden. Insbesondere, wenn der Verbinder mit einer Solarzellenelektrode über einen elektrisch leitfähigen Kleber verklebt wird, kann eine oxidfreie Verbinderoberfläche vorteilhaft sein, da dies eine optimale Haftung ermöglicht.

Die metallische Beschichtung kann auf verschiedenen, bekannten Wegen aufgetragen werden. Vorzugsweise kann die metallische Beschichtung aufgebracht werden durch ein Verfahren, das ausgewählt ist aus der Gruppe bestehend aus Tauchbeschichtung, chemischer Gasphasenabscheidung (CVD), physikalische Gasphasenabscheidung (PVD), elektrolytischer Abscheidung, Drucken, stromlose Metallabscheidung und Walzplattieren.

Unter Tauchbeschichten ist im vorliegenden Fall das Eintauchen einer Leiterstruktur in eine Schmelze eines beschichtenden Materials zu verstehen. Die Schmelze ist bevorzugt ein Lotbad. Drucken meint im Rahmen der Erfindung, dass eine Paste, die zumindest leitfähige Metallpartikel und ein organisches Medium enthält, auf der Aluminiumleiterstruktur aufgedruckt und anschließend unter Verflüchtigung des organischen Mediums fixiert wird z.B. durch Einbrennen oder Sintern.

In einer weiteren bevorzugten Ausführungsform kann die Leiterstruktur mehr als eine metallische Beschichtung aufweisen. Beispielsweise kann eine erste metallische Beschichtung aufgetragen werden, die die Korrosion der Aluminiumleiterstruktur hemmt bzw. verhindert und eine weitere metallische Beschichtung kann auf der ersten metallischen Beschichtung aufgetragen werden, um die Verbindung zur Solarzellenelektrode zu ermöglichen. Beispielsweise kann die weitere metallische Beschichtung eine Lotbeschichtung sein.

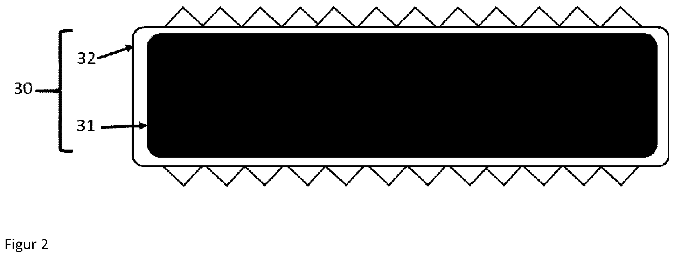

Bevorzugt weist die metallische Beschichtung und/oder die Leiterstruktur auf der Seite der Sonneneinstrahlung eine strukturierte Oberfläche auf (siehe beispielsweise Figur 2). Wenn eine Solarzelle in ein fertiges Modul eingebaut ist, enthält das Modul typischer Weise eine Schutzschicht über der Solarzelle, die vor Umwelteinflüssen schützen soll. Diese Schutzschicht ist bevorzugt eine Glasschicht. Die Strukturierung ist so ausgestaltet, dass einfallendes Sonnenlicht so vom Verbinder reflektiert wird, dass es in einem Photovoltaikmodul in die vorhandene Schutzschicht effektiv einkoppeln kann (z.B. durch interne Totalreflektion) und nicht aus dem Photovoltaikmodul entweicht. Dadurch wird es ermöglicht, dass vom Verbinder reflektiertes Sonnenlicht in der Solarzelle zur Erzeugung von Ladungsträgern zusätzlich zur Verfügung steht Die Strukturierung kann eine regelmäßige oder ein unregelmäßige Strukturierung aufweisen. Beispielsweise kann die Strukturierung ein regelmäßiges Sägezahnmuster aufweisen, so wie es in Figur 2 dargestellt ist. Regelmäßige Strukturierungen lassen sich einfach während der Herstellung des Verbinders durch Prägen erzeugen.

In einer bevorzugten Ausführung enthält die Strukturierung strukturbildende Elemente mit ebenen Flächenbereichen, die relativ zur Oberflächenrichtung um 20 - 40° gekippt sind. Bevorzugt liegt der Abstand der Maxima von zwei benachbarten strukturbildenden Elementen (z.B. von zwei Sägezähnen) im Bereich von 10 µm - 500 µm, insbesondere im Bereich von 50 µm - 300 µm und ganz besonders bevorzugt im Bereich von 100 - 200 µm. Dies führt dazu, dass einfallendes Sonnenlicht effizient in die Solarzelle zurück reflektiert werden kann.

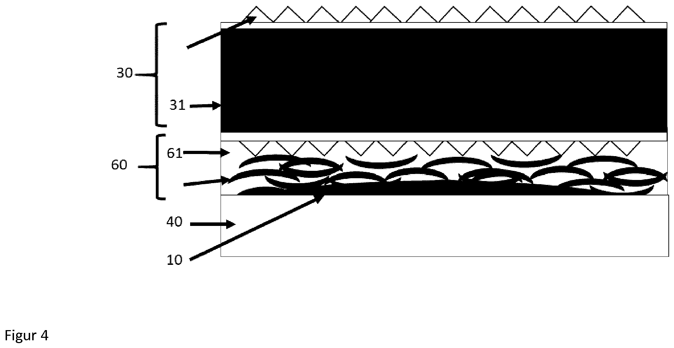

In einer anderen bevorzugten Ausführungsform weist die metallische Beschichtung und/oder die Leiterstruktur auf der mit der Elektrode in Kontakt stehenden Seite des Verbinders eine die Oberfläche, im Vergleich zu einer ebenen Fläche, vergrößernde Struktur auf (Figur 4). Bevorzugt wird die Oberfläche durch Ätzen aufgeraut. Diese die Oberfläche vergrößernde Struktur kann die mechanische Haftung zwischen Verbinder und Solarzellelektrode erhöhen, insbesondere beim Verkleben mit Hilfe eines elektrisch leitfähigen Klebers.

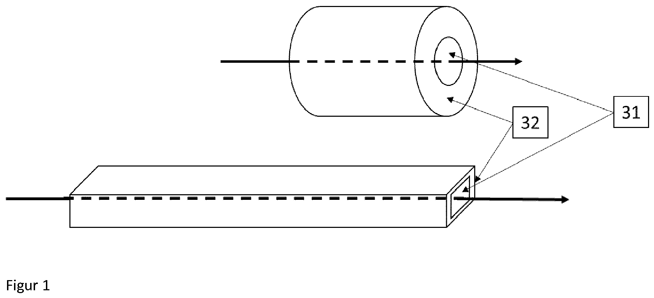

Beispielhafte Verbinder sind in Figur 1 dargestellt. Die skizzierten Pfeile geben jeweils die Hauptachse des Verbinders an. Figur 1 zeigt zwei unterschiedliche Ausführungen, bei denen eine Leiterstruktur (31) entlang der Hauptachse von einer metallischen Beschichtung (32) umgeben ist.

In einer Ausführungsform betrifft die Erfindung ein Photovoltaikbauteil umfassend eine Solarzelle, deren Solarzellenelektrode über einen Verbinder mit einem weiteren Element verbunden ist, wobei der Verbinder eine Leiterstruktur umfasst, auf der mindestens eine metallische Beschichtung angeordnet ist und wobei die Leiterstruktur Aluminium enthält, dadurch gekennzeichnet, dass die Beschichtung ein Element enthält, das aus der Gruppe ausgewählt ist, die aus Ni, Ag, Sn, Pb , Zn, Bi, In, Sb, Co, Cr sowie Legierungen dieser Elemente besteht.

Die Solarzellenelektrode ist auf einer Solarzelle angeordnet. Eine Solarzelle enthält bevorzugt mindestens ein Halbleitersubstrat, das von mindestens zwei Solarzellenelektroden unterschiedlicher Polarität kontaktiert wird. Das Halbeitersubstrat ist bevorzugt ein dotierter Siliziumwafer. Bevorzugt ist das Halbleitersubstrat ein monokristalliner oder multikristalliner Siliziumwafer. Bevorzugt umfassen, die mindestens zwei Solarzellenelektroden mindestens eine Rückseitenelektrode und mindestens eine Frontseitenelektrode. In einer anderen Ausführungsform können die mindestens zwei Elektroden auch auf der gleichen Seite des Halbleitersubstrats angeordnet sein.

Die Rückseitenelektrode kann zum Beispiel eine flächig aufgetragene Metallschicht sein. Vorzugsweise enthält diese Metallschicht Aluminium, insbesondere mit Kontaktbereichen aus Silber. Die Frontseitenelektrode ist bevorzugt eine Fingerelektrode oder ein Busbar. Unter einer Fingerelektrode ist eine Elektrode zu verstehen, die als einige Mikrometer dünne Linie auf der Solarzelle angeordnet ist und dazu dient möglichst über die gesamte Flächen der Solarzelle Ladungsträger einzusammeln. Typischer Weise überspannt eine Vielzahl von Fingerelektroden die Frontseite einer Solarzelle, insbesondere einer Siliziumsolarzelle. Bevorzugt lieg der mittlere Durchmesser einer Fingerelektrode im Bereich von 20 - 150 µm. Eine Busbar verbindet typischer Weise mehrere Fingerelektroden und dient dazu, den von den Fingerelektroden gesammelten Strom effizient abzuleiten. Gleichzeitig kann ein Busbar dazu dienen mechanisch robuste Kontaktflächen, z.B. zum Löten, zur Verfügung zu stellen. Ein Busbar hat bevorzugt einen größeren Leitungsquerschnitt als eine Fingerelektrode. Der typische Durchmesser eines Busbars liegt im Bereich von 100 µm - 2 mm und die Höhe beträgt bevorzugt 1 - 20 µm. Bevorzugt weist ein Busbar eine geringere Haftung zum Halbleitersubstrat auf als die Fingerelektroden, die dieser miteinander verbindet.

In einer bevorzugten Ausführung ist auf einer Fingerelektrode zusätzlich ein Busbar angeordnet. In einer bevorzugten Ausführungsform kontaktiert ein Busbar mehrere oder alle vorhandenen Fingerelektroden und der Verbinder kontaktiert mindestens einen Busbar.

In einer anderen bevorzugten Ausführungsform besteht die Solarzellenelektrode aus mehreren Fingerelektroden wobei der Verbinder mindestens eine Fingerelektrode unmittelbar kontaktiert. Somit kann der Verbinder mehrere Fingerelektroden direkt mit einem weiteren Element verbinden, ohne dass die Fingerelektroden untereinander mit einem Busbar verbunden sind. Diese Ausführungsform hat den Vorteil, dass der Herstellungsschritt für den Busbar entfallen kann und somit die Herstellung vereinfacht.

Sowohl die Rückseitenelektrode als auch die Frontseitenelektrode werden bevorzugt hergestellt, indem eine Leiterpaste auf der Halbleiterschicht aufgetragen wird und die aufgetragene Leiterpaste anschließend eingebrannt wird. Die Leiterpaste kann durch Drucken, wie z.B. Siebdrucken oder Schablonendrucken, auf der Halbleiterschicht aufgetragen werden. Eine Leiterpaste umfasst typischer Weise elektrisch leitfähige Metallpartikel, eine Glasfritte und ein organisches Medium. Wenn die Leiterpaste zur Herstellung einer Rückseitenpaste eingesetzt wird, enthalten die elektrisch leitfähigen Metallpartikel bevorzugt Aluminium oder bestehen aus Aluminium. Wenn die Leiterpaste zur Herstellung einer Frontseitenpaste eingesetzt wird, enthalten oder bestehen die elektrisch leitfähigen Metallpartikel bevorzugt aus Silber. Nach dem Auftragen kann das Halbleitersubstrat zusammen mit der bzw. den aufgetragenen Leiterpasten gebrannt werden, wodurch die eine Solarzellelektrode erhalten wird. Durch das Brennen kann das organische Medium entfernt werden und eine mechanisch feste und elektrisch leitfähige Elektrode erhalten werden. Die erhalten Solarzellelektroden umfassen somit bevorzugt eine Mischung aus Glas und Metall.

In dem erfindungsgemäßen Photovoltaikbauteil wird die Solarzellenelektrode über einen Verbinder mit einem weiteren Element verbunden. Bevorzugt ist das weitere Element eine weitere Solarzellenelektrode einer Solarzelle. Besonders bevorzugt ist das weitere Element eine weitere Solarzellenelektrode mit entgegengesetzter Polarität zur ersten Solarzellenelektrode. Das bedeutet, dass eine positive Elektrode auf einer ersten Solarzelle mit einer negativen Elektrode auf einer weiteren Solarzelle verbunden werden kann.

In einer bevorzugten Ausführung ist der Kontakt zwischen der Solarzellenelektrode und dem Verbinder eine elektrisch leitfähige Klebeverbindung, eine Schweißverbindung oder eine Lotverbindung. Für den Fall, dass eine Lotverbindung hergestellt wird, kann das Lot nicht direkt auf Aluminium aufgebracht werden, ohne ein hindernde Oxidschicht zu erzeugen. Es ist dem Fachmann jedoch bekannt, dass Aluminiumbauteile mit Hilfe einer dünnen Zwischenschichten (z.B. einer Zinnschicht) verlötet werden können. Das Schweißen kann bevorzugt Ultraschallschweißen sein. Die Klebeverbindung besteht bevorzugt aus einem duroplastischen oder thermoplastischen Polymer, in dem leitfähige Metallpartikel, insbesondere Silberpartikel, eingebettet sind.

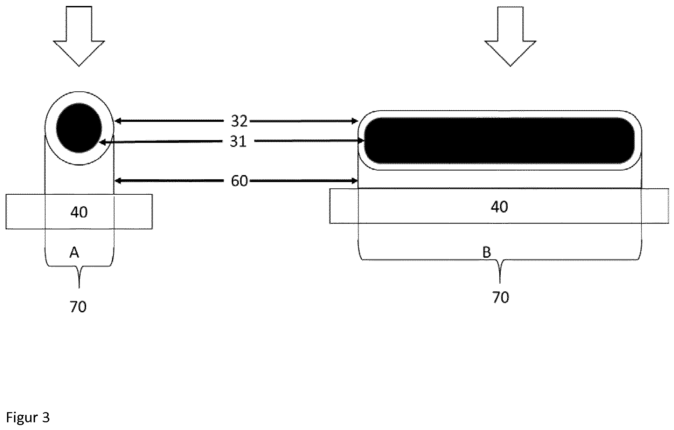

Um dauerhaft eine hohe Leitfähigkeit des Kontakts Solarzellenelektrode und Verbinder aufrechtzuerhalten, ist es besonders vorteilhaft, wenn der Verbinder eine möglichst große Kontaktfläche mit der zu verbindenden Solarzellenelektrode aufweist. Insbesondere wird der elektrische Kontakt dabei flächig hergestellt. Flächig bedeutet, dass der Verbinder möglichst über seine ganze Projektion senkrecht zur Oberfläche (70) mit der Solarzellenelektrode verbunden ist, so wie es in Figur 3 dargestellt ist. (Pfeil gibt Projektion senkrecht zur Oberfläche der Solarzelle an).

Das erfindungsgemäße Photovoltaikbauteil, kann durch die folgenden Schritte hergestellt werden:
a) Bereitstellen einer Solarzelle aufweisend mindestens einer Solarzellelektrode
b) Bereitstellen eines weiteren Elements
c) Verbinden der Solarzellelektrode und des weiteren Elements mit dem erfindungsgemäßen Verbinder.

Die Verbindung zwischen der Solarzellelektrode und dem Verbinder bzw. dem Verbinder und dem weiteren Element in Schritt c) kann auf verschiedene Arten hergestellt werden. Bevorzugt erfolgt die Verbindung durch Verkleben mit einem elektrisch leitfähigen Kleber, Verschweißen oder Verlöten. Bevorzugt erfolgen das Verbinden des Verbinders mit der Solarzellenelektrode und das Verbinden des Verbinders mit dem weiteren Element mit demselben Verfahren. Optional können auch das Verbinden der Solarzelle und mit dem Verbinder und das Verbinden des weiteren Elements mit dem Verbinder auch auf verschiedene Arten erfolgen.

Die maximalen Temperatur, der eine Solarzelle, insbesondere eine Siliziumsolarzelle, ausgesetzt werden kann, liegt im Bereich von 750°C - 900°C. Wenn das Material der metallischen Beschichtung auf dem Verbinder einen Schmelzpunkt oberhalb dieses Temperaturbereichs hat, kann der Verbinder nicht mit der Solarzellenelektrode verlötet oder verschweißt werden, da diese Temperaturen die Solarzelle zerstören könnten. Beispielsweise hat Nickel einen Schmelzpunkt von 1455°C, was deutlich über dem für die Solarzelle akzeptablen Temperaturbereich liegt. Wenn ein hochschmelzendes Metall wie Nickel mittels Löten oder Schweißen mit der Solarzellenelektrode verbunden werden sollte, wären Temperaturen oberhalb des Schmelzpunktes notwendig, die eine Solarzelle zerstören können. Um die thermische Belastung zu verringern, kann es daher vorteilhaft sein, die Kontaktierung der Solarzellelektrode mit dem Verbinder durch einen leitfähigen Klebstoff herzustellen, der bei Raumtemperatur oder im Temperaturbereich bis maximal 200°C verarbeitet werden kann.

In einer bevorzugten Ausführungsform wird die Verbindung zwischen Solarzellenelektrode und dem Verbinder beziehungsweise zwischen dem Verbinder und dem weiteren Element mit Hilfe eines elektrisch leitfähigen Klebers hergestellt.

Als elektrisch leitfähiger Kleber können beispielsweise Zusammensetzungen eingesetzt werden die eine Mischung aus leitfähigen Metallpartikeln und einem polymeren Klebstoffsystem enthalten. Das Material der leitfähigen Metallpartikel kann beispielsweise ausgewählt sein aus Kupfer, Silber, Nickel sowie Legierungen dieser Metalle. Optional kann ein elektrisch leitfähiger Kleber anorganische Füllstoffe enthalten.

Das polymere Klebstoffsystem kann beispielsweise ein aushärtendes Klebstoffsystem sein, das nach dem Aushärten duroplastische Eigenschaften aufweist, d.h. ein Material, das nach dem Aushärten nicht mehr thermisch verformt werden kann. Aushärtende Klebstoffsysteme für elektrisch leitfähige Klebstoffe sind dem Fachmann bekannt und können je nach geforderter Anwendung ausgewählt werden. Das Aushärten kann auf verschiedene Arten initiiert werden. Beispielsweise kann das Aushärten chemisch (z.B. durch Feuchtigkeit), thermisch oder mit Licht geeigneter Wellenlänge initiiert werden. Der elektrisch leitfähige Kleber kann beispielsweise ein mit Nickel- oder Silberpartikeln gefülltes Epoxidharz sein.

Das polymere Klebstoffsystem kann ein selbsthärtendes Ein - Komponenten - System oder ein Zwei-Komponenten-System sein. In einer besonders bevorzugten Ausführung ist das polymere Klebstoffsystem ein UV-härtendes Klebstoffsystem. Das Aushärten wird bevorzugt durch Vernetzung einzelner Polymerketten zu einem zusammenhängenden Netzwerk erreicht.

Der elektrisch leitfähige Kleber kann durch Drucken (z.B. Siebdruck oder Schablonendruck) aufgetragen werden. Der elektrisch leitfähige Kleber kann entweder auf der zu verbindenden Elektrode oder auf dem Aluminiumverbinder oder auf beiden aufgetragen werden. Der mit elektrisch leitfähigem Klebstoff bedruckte Bereich ist nicht auf die Elektrode beschränkt. Nachdem die Solarzellelektrode über den elektrisch leitfähigen Kleber mit dem Verbinder in Kontakt gebracht wird, kann der elektrisch leitfähige Kleber ausgehärtet werden.

In einer alternativen Ausführungsform kann eine doppelseitig klebende Folie verwendet werden, die in den Kontaktbereich zwischen Solarzellenelektrode und dem Verbinder gebracht wird. In einer bevorzugten Ausführungsform wird die doppelseitige Folie auf die Solarzelle aufgeklebt und dann der Aluminiumverbinder auf den mit der Folie beklebten Bereich aufgebracht. Optional kann die Folie nachträglich, z.B. durch thermische Behandlung, ausgehärtet werden.

In einer weiteren alternativen Ausführungsform kann die doppelseitig klebende Folie auch zuerst auf dem Verbinder aufgetragen werden und anschließend mit der Solarzellenelektrode kontaktiert werden.

Im Folgenden soll die Erfindung anhand von Ausführungsbeispielen verdeutlicht werden.

### Beispiele

### Bereitstellung von Solarzellen

Als Solarzelle wurde eine p-Typ Zelle mit n-Emitter der Fa. Q-Cells eingesetzt (Widerstand: 90 Ohm/square). Die Oberfläche wies eine Si₃Nₓ Antireflektiv-Beschichtung auf der Vorderseite auf. Mit der kommerziell erhältlichen Paste Heraeus SOL 9631 C wurden Finger und Busbars auf der Vorderseite mittels Siebdruck aufgetragen. Die Linienbreite der Finger betrug 40 µm. Siebgedruckte Silber-Lötpads wurden auf der Rückseite mit der kommerziellen Paste Heraeus SOL205B aufgebracht. Die Aluminium - BSF auf der Rückseite wurde mittels siebgedruckter kommerzieller Aluminium-Paste ((RUX28K30, Guangzhou Ruxing Technology Development Co., Ltd. of Guangdong, China) aufgedruckt.

Die Pasten wurden getrocknet und mit einer Maximaltemperatur von 900°C eingebrannt.

### Beschichtung

Mehrere Aluminiumbänder (1,5 mm Breite, 300 µm Dicke) wurden mit unterschiedlichen metallischen Beschichtung versehen.

Beschichtung mit Silber:
Das zu plattierende Aluminiumband wurde auf beiden Seiten nach DIN 17611 gebürstet, entfettet und desoxidiert werden. Das vorbehandelte Aluminiumband wurde auf ein entfettetes und gereinigtes Silberband gelegt. Das Aluminiumblech wurde wiederum mit einer entfetteten und gereinigten Silberband abgedeckt, wodurch ein so genannter Stapel entstand.

Die Dicke jeder Schicht wurde so gewählt, dass das Verhältnis der Schichtdicken zueinander dem späteren Zielverhältnis im gewalzten Stapel entsprach. Der Stapel wurde in dem Walzspalt einer Kaltwalzplattier-Anlage zusammengeführt und mit einem hohen Druck kontinuierlich zu einem Verbundwerkstoff kaltpressverschweißt. Der Stapel wurde im anschließend mehrfach nachgewalzt und dadurch in der Dicke reduziert. Der fertige Verbinder wies eine Schichtdicke von 300 µm auf, wobei die Dicke der Beschichtung etwa 5 µm betrug.

Beschichtung mit Nickel:
Das zu plattierende Aluminiumband wurde auf beiden Seiten nach DIN 17611 gebürstet, entfettet und desoxidiert werden. Das vorbehandelte Aluminiumband wurde auf ein entfettetes und gereinigtes Nickelband gelegt. Das Aluminiumband wurde wiederum mit einem entfetteten und gereinigten Nickelband abgedeckt, wodurch ein so genannter Stapel entstand. Die Dicke jeder Schicht wurde so gewählt, dass das Verhältnis der Schichtdicken zueinander dem späteren Zielverhältnis im gewalzten Stapel entsprach. Der Stapel wurde in dem Walzspalt einer Kaltwalzplattier-Anlage zusammengeführt und mit einem hohen Druck kontinuierlich zu einem Verbundwerkstoff kaltpressverschweißt. Der Stapel wurde anschließend mehrfach nachgewalzt und dadurch in der Dicke reduziert. Der fertige Verbinder wies eine Dicke von 300 µm auf, wobei die Dicke der Nickelbeschichtung etwa 5 µm betrug.

### Beschichtung mit Sn60Pb40

Das zu plattierende Aluminiumband wurde auf beiden Seiten nach DIN 17611 gebürstet, entfettet und desoxidiert werden. Das vorbehandelte Aluminiumband wurde auf ein entfettetes und gereinigtes Sn60Pb40-Band gelegt. Das Aluminiumband wurde wiederum mit einem entfetteten und gereinigten Sn60Pb40-Band abgedeckt, wodurch ein so genannter Stapel entstand. Die Dicke jeder Schicht wurde so gewählt, dass das Verhältnis der Schichtdicken zueinander dem späteren Zielverhältnis im gewalzten Stapel entsprach. Der Stapel wurde in dem Walzspalt einer Kaltwalzplattier-Anlage zusammengeführt und mit einem hohen Druck kontinuierlich zu einem Verbundwerkstoff kaltpressverschweißt. Der Stapel wurde anschließend mehrfach nachgewalzt und dadurch in der Dicke reduziert. Der fertige Verbinder wies eine Dicke von 300 µm auf, wobei die Dicke der Nickelbeschichtung etwa 5 µm betrug.

### Verkleben

Ein silberhaltiger Leitkleber wurde mittels Schablonendruck auf der Solarzelle als 1,5 mm breiter und 150 mm langer Kleberstreifen je Busbar appliziert. Die Klebermenge betrug 80 mg pro Solarzelle (Klebertyp PC 4000 (Fa. Heraeus)). Die vorher mit einer metallischen Beschichtung beschichteten Aluminiumverbinder wurden mit einem Löttisch (Consol 2010, Somont GmbH, Deutschland) auf den Kleberstreifen gedrückt. Der Kleber wurde unter Druck für 10 Minuten bei 150° auf dem Löttisch ausgehärtet.

### Alterung der Proben

An den hergestellten Solarzellen wurden zwei Alterungstest durchgeführt:
a) Thermische Alterung: Nach 48, 100 und 500 h bei 150°C an Luft im Umlufttrockenschrank wurde jeweils an zehn Solarzellen die unten beschriebene elektrische Zellcharakterisierung durchgeführt.
b) Klimatest: Nach 100, 500 und 1000 h bei 85°C und 85% relativer Luftfeuchte im Umluftklimaschrank (Fa. Vötsch VC0034, Deutschland) wurde jeweils an zehn Solarzellen die unten beschriebene elektrische Zellcharakterisierung durchgeführt.

### Elektrische Charakterisierung

Die Messung des Füllfaktors (FF) der Probe vor und nach den Alterungstests wurde mit dem Zelltester "H.A.L.M. cetisPV-Celltest" (Fa. Halm Elektronik GmbH) bei 25°C durchgeführt. Die Zelle wurde mit einer Xe Arc Lampe mit einem der Sonne ähnlichen Lichtspektrum mit AM 1.5 bei einer Intensität von 1000 W/m² bestrahlt. Der Halm IV-Tester benutzt zur Kontaktierung einen Mehrpunktkontakt, um Strom (I) und Spannung (V) zu erfassen. Dabei sind die Kontaktfinger des Messgerätes in direktem Kontakt mit den Busbars der Solarzelle. Die Anzahl der Kontaktfinger stimmt mit der Anzahl der Busbars überein. Die erfassten elektrischen Werte wurden über die geräteigene Software aufgezeichnet und ausgewertet. Als Referenz wurde eine kalibrierte Standard-Solarzelle (Fraunhofer Instituts für Solare Energiesysteme (ISE) Freiburg, Deutschland) mit gleichen Abmessungen, gleichem Wafer-Material nach oben beschriebenen Weg prozessiert und die erzeugten elektrischen Daten mit den zertifizierten Werten verglichen. Pro durchgeführtem Lagerungsversuch wurden zehn Wafer getestet und der Median für den Füllfaktor (FF) berechnet.

### Mechanische Charakterisierung

Die Abzugskraft (F), die notwendig ist, um einen erfindungsgemäßen Verbinder von einem Busbar abzuziehen, wurde vor und nach der Alterung mit einem Abzugstester GP-Stab-Test-Pro (GP Solar GmbH, Deutschland) unter Anwendung eines Abzugswinkels von 45° gemessen.

Der Verbinder wurde im Testkopf eingeklemmt und mit einer Geschwindigkeit von 300 mm/min im Winkel von 45° abgezogen. Die ermittelte Abzugskraft wurde über den Verlauf des Weges aufgezeichnet und der Minimalwert in Newton ermittelt. Der Prozess wurde insgesamt mit 10 Busbars durchgeführt und der Median ermittelt. Die Ergebnisse sind in Tabelle 1 zusammengefasst.

**Tabelle 1**

| Bändchen / Beschichtung | Abziehkraft F (vorher) | Abziehkraft F (nach thermischer Alterung) | Abziehkraft F (nach Klimatest 85°,85%) | Füllfaktor (vorher) | Füllfaktor (nach thermischer Alterung | Füllfaktor (nach Klimatest 85°,85%) |
|---|---|---|---|---|---|---|
| Al | + | - | - | + | - | - |
| Al/Ni | ++ | ++ | + | + | + | + |
| Al/Sn60Pb40 | + | + | + | + | + | + |
| Al/Ag | +++ | +++ | ++ | + | + | + |

## Patentansprüche

1. Verbinder zum Verbinden einer Solarzellenelektrode mit einem weiteren Element, wobei der Verbinder eine Leiterstruktur umfasst, auf der mindestens eine metallische Beschichtung angeordnet ist, wobei die Leiterstruktur Aluminium enthält, **dadurch gekennzeichnet, dass** die Beschichtung ein Element enthält, das aus der Gruppe ausgewählt ist, die aus Ni, Ag, Sn, Pb, Zn, Bi, In, Sb, Co, Cr sowie Legierungen dieser Elemente besteht.

2. Verbinder nach Anspruch 1, wobei die Leiterstruktur ein Band oder eine Draht ist.

3. Photovoltaikbauteil umfassend eine Solarzelle, deren Solarzellenelektrode über einen Verbinder mit einem weiteren Element verbunden ist, wobei der Verbinder eine Leiterstruktur umfasst, auf der mindestens eine metallische Beschichtung angeordnet ist und wobei die Leiterstruktur Aluminium enthält, **dadurch gekennzeichnet, dass** die Beschichtung ein Element enthält, das aus der Gruppe ausgewählt ist, die aus Ni, Ag, Sn, Pb , Zn, Bi, In, Sb, Co, Cr sowie Legierungen dieser Elemente besteht.

4. Photovoltaikbauteil gemäß Anspruch 3, wobei der Verbinder durch einen elektrisch leitfähigen Klebstoff mit der Solarzellenelektrode verbunden ist.

5. Photovoltaikbauteil gemäß einem der Ansprüche 3 oder 4, wobei die Solarzellenelektrode eine Fingerelektrode oder ein Busbar ist.

6. Photovoltaikbauteil gemäß einem der Ansprüche 5, wobei der Verbinder mindestens eine Fingerelektrode unmittelbar kontaktiert.

7. Photovoltaikbauteil gemäß einem der Ansprüche 3 - 6, wobei die metallische Beschichtung auf der lichteinfallenden Seite eine Strukturierung enthält, wobei die Strukturierung strukturbildende Elemente mit Flächenbereichen aufweist, die relativ zur Oberflächenrichtung um 20 - 40° gekippt sind.

8. Photovoltaikbauteil gemäß einem der Ansprüche 3 - 7, **dadurch gekennzeichnet, dass** die metallische Beschichtung auf der mit der Elektrode in Kontakt stehenden Seite eine die Oberfläche, im Vergleich zu einer ebenen Fläche, vergrößernde Struktur aufweist, die geeignet ist, die Haftung zu erhöhen.

9. Photovoltaikbauteil gemäß einem der Ansprüche 3 - 8, wobei das weitere Element eine weitere Solarzellenelektrode ist.

10. Verfahren zur Herstellung eines Photovoltaikbauteils, umfassend die Schritte
a. Bereitstellen einer Solarzelle aufweisend mindestens einer Solarzellelektrode
b. Bereitstellen eines weiteren Elements
c. Verbinden der Solarzellelektrode und des weiteren Elements mit einem Verbinder gemäß einem der Ansprüche 1 oder 2.

11. Verfahren gemäß Anspruch 10, wobei in Schritt c) der Verbinder auf der Solarzellelektrode mit einem elektrisch leitfähiger Kleber befestigt wird.

12. Verfahren gemäß Anspruch 11, wobei die metallische Beschichtung auf dem Verbinder hergestellt wird mit einem Verfahren, das ausgewählt ist aus der Gruppe bestehend aus Tauchbeschichten, Schmelzbeschichten, chemische Gasphasenabscheidung(CVD), physikalische Gasphasenabscheidung (PVD), galvanische Beschichtung, Drucken, *Electroless Plating* und Walzplattieren.

13. Verwendung von Verbindern gemäß Anspruch 1 oder 2 zum Verbinden einer Solarzellenelektrode mit einem weiteren Element.
